(19) Europäisches Patentamt / European Patent Office / Office européen des brevets

(11) **EP 1 936 694 B1**

(12) **EUROPEAN PATENT SPECIFICATION**

(45) Date of publication and mention
of the grant of the patent:
**26.11.2014 Bulletin 2014/48**

(51) Int Cl.:
***H01L 27/146*** (2006.01)

(21) Application number: **07024643.4**

(22) Date of filing: **19.12.2007**

(54) **Image detector and radiation detecting system**

Bilddetektor und Strahlungsdetektionssystem

Détecteur d'images et système de détection de radiations

(84) Designated Contracting States:
**BE DE FR NL**

(30) Priority: **20.12.2006 JP 2006342754**
**17.12.2007 JP 2007324263**

(43) Date of publication of application:
**25.06.2008 Bulletin 2008/26**

(60) Divisional application:
**13191648.8 / 2 696 367**

(73) Proprietor: **FUJIFILM Corporation**
**Tokyo 106-0031 (JP)**

(72) Inventors:
• **Okada, Yoshihiro**
**Ashigarakami-gun,**
**Kanagawa (JP)**
• **Yoshimi, Takuya**
**Ashigarakami-gun,**
**Kanagawa (JP)**

(74) Representative: **Klunker . Schmitt-Nilson . Hirsch**
**Patentanwälte**
**Destouchesstraße 68**
**80796 München (DE)**

(56) References cited:
**EP-A2- 1 120 833        WO-A1-2004/073067**
**WO-A1-2004/077098    US-A1- 2002 076 861**
**US-A1- 2005 018 097    US-B1- 6 323 490**

**Description**

Field of the invention

The present invention relates to an image detector which is a direct conversion type image detector that directly converts irradiated radiation to electric charges in a semiconductor film. A thin film transistor is two-dimensionally arrayed and specifically relates to a structure of the pixel thereof.

Description of the Related Art

A FPD (Flat Panel Detector) in which an X-ray sensitive layer is disposed on a TFT active matrix substrate and is capable of converting X-ray information directly into digital data, has been put into practice lately. The FPD has merit that enables one to instantly confirm images and even video images as compared to a prior art imaging plate. Therefore, it is spreading rapidly.

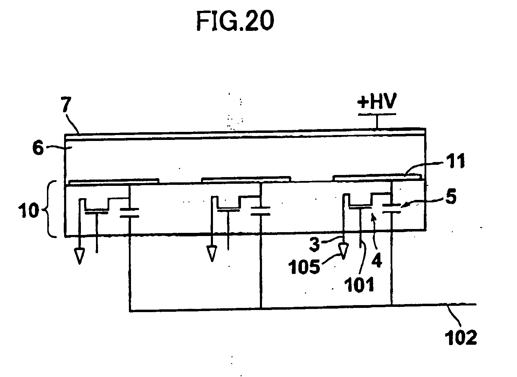

At first, radiation image detector using the FPD will be explained with reference to Fig. 20.

The radiation image detector has been constructed by forming a semiconductor film 6, having electromagnetic wave conductivity on an active matrix substrate 10 in which charge collecting electrodes 11 are disposed in array, and by forming a bias electrode 7 on the semiconductor film 6. Further, the upper electrode 7 is connected to a high voltage source.

The semiconductor film 6 is an amorphous selenium (a-Se) film of 100 to 1000 $\mu$m including selenium as a main component, and generates electric charges within the film when it is irradiated by X-rays. A TFT switch 4 and a charge storage capacitor 5 are provided in the vicinity of the charge collecting electrode 11 disposed in array on the active matrix substrate 10 and a drain electrode of the TFT switch 4 is connected with one electrode of the charge storage capacitor 5. Another electrode of the charge storage capacitor 5 is connected with a storage capacitor line 102. A scan line 101 is connected to a gate electrode of the TFT switch 4, and a data line 3 is connected to a source electrode. A signal detector (amplifier) 105 is connected to a terminal end of the data line 3 see JP 11-190774 and JP 2001-135809 for example).

Next, a principle of operation of the above mentioned radiation image detector will be explained.

When the X-rays are irradiated from the upper part in Fig. 20, the semiconductor film 6 generates electric charges therein. Among the generated charges, positive holes are collected to the charge collecting electrode 11 by electric potential difference between the bias electrode 7 and the charge collecting electrode 11 and are stored in the charge storage capacitor 5 electrically connected with the charge collecting electrode 11. Because the semiconductor film 6 generates a different amount of electric charges corresponding to a dosage of X-rays, charges corresponding to image information carried by the X-rays are stored in the charge storage capacitor 5 of each pixel. After that, signals for turning the TFT switch 4 ON are sequentially added through the scan line 101 to take out the charges stored in each of the charge storage capacitors 5 via the data line 3. Then it becomes possible to read the image information by detecting an amount of charges of each pixel by the signal detector 105.

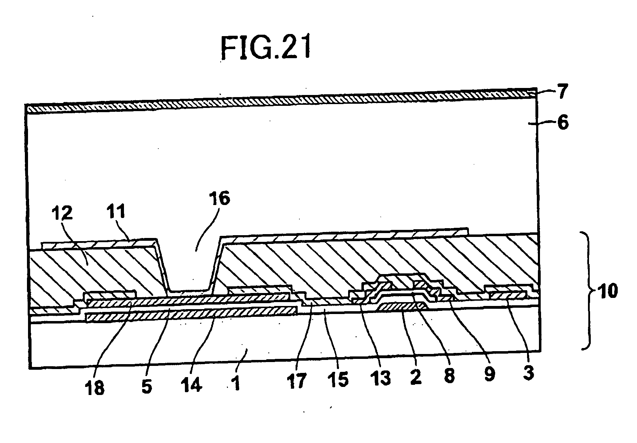

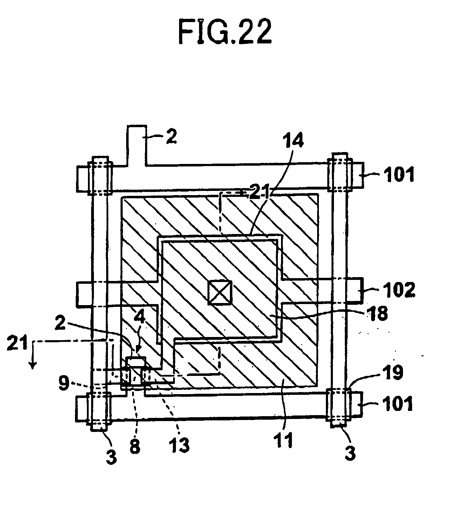

Next, a structure of the pixel when the TFT active matrix substrate is manufactured by using a technology for manufacturing a general liquid crystal panel or the like will be explained. Fig. 21 is a section view showing a structure of one pixel unit of the radiation image detector and Fig. 22 is a plan view thereof. Fig. 21 is a section view taken along a line 21-21 in Fig. 22.

As shown in Fig. 21 and Fig. 22, the radiation image detector has a gate electrode 2, the scan line 101, a storage capacitor lower electrode 14 and a storage capacitor line 102 on a glass substrate 1. Then, a gate insulating film 15 is provided on the gate electrode 2, the scan line 101, the storage capacitor lower electrode 14 and the storage capacitor line 102. A semiconductor layer 8 is formed on the gate electrode 2 through an intermediary of the gate insulating film 15. Then, source and drain electrodes 9 and 13 are formed on the semiconductor layer 8. A storage capacitor upper electrode 18 is deposited on a layer composing the charge storage capacitor 5. Then, a data line 3 is provided in the same metal layer with the source electrode 9, the drain electrode 13 and the storage capacitor upper electrode 18. Then, an insulation protecting film 17 is disposed above the data line 3, the storage capacitor upper electrode 18, the source and drain electrodes 9 and 13.

Further, an interlayer insulating film 12 is provided on the insulation protecting film 17. The charge collecting electrode 11 is provided on the interlayer insulating film 12, i.e., at the uppermost layer of the active matrix substrate 10. The charge collecting electrode 11 is connected with the TFT switch 4 via the storage capacitor upper electrode 18 and the drain electrode 13. Furthermore, the data line 3 crosses with the scan line 101 and the storage capacitor line 102 via the gate insulating film 15. Then, the semiconductor film 6 and the bias electrode 7 are formed on the active matrix substrate 10.

In a radiation image detector configured as above, there are two important problems which need to be addressed, these being the drop in production yield of the TFT array and deterioration of the image quality of detected images.

Explanation will first be given of the problem of the production yield of the TFT array.

Defects during production of the TFT array may be divided into the categories of line defects and point defects. Of these, correction of the point defects is possible in the image detector by image correction in image processing, and therefore point defects do not present a major problem. However, line defects, including leakage of storage capacitor lines, scan lines, and data lines, are difficult to physically repair by laser repair or the like in the TFT array process, and also are difficult to rectify by image correction. Therefore, line defects are critical defects and are a cause of increased production costs for TFT arrays.

The scan lines, gate electrodes and storage capacitor line in FIG. 21 are all formed to the same metal layer (gate layer). Therefore, patterning defects occur when forming the gate layer, and if conductive material remains between the storage capacitor line and either the scan lines or the gate electrodes, leak may occur between the scan lines and the storage capacitor lines.

Such defects occur more frequently as the resolution of the image detector gets finer.

Explanation will now be given of the problem of detected images.

It is obviously essential to reduce electronic noise of the radiation image detector to improve image quality of detected images in the radiation image detector constructed as described above. The electronic noise is influenced largely by data line noise caused by a line capacitance in the radiation image detector using the active matrix substrate constructed as described above. Accordingly, in order to improve the image quality of detected images, a reduction in the line capacitance of the data lines is needed.

The line capacitance of the data line, represented as Cd_line, may be expressed as follows:

$$\text{Cd\_line} = \text{Ngate} \times (\text{Cdgx} + \text{Cdcsx} + \text{Ctft} + \text{Cdp}) + \text{Ccom}$$

Where, Ngate is a number of scan lines crossing with the data line, Cdgx is a capacitance at an intersection of the data line and the scan line, Cdcsx is a capacitance of an intersection of the data line and the storage capacitor line, Ctft is a capacitance of the TFT section between the data line and the TFT switch, Cdp is a coupling capacitance between the data line and the charge collecting electrode and Ccom is a capacitance between the bias electrode and the data line.

Because Com and Cdp are normally small and may be omitted, Cd_line may be expressed as follows:

$$\text{Cd\_line} = \text{Ngate} \times (\text{Cdgx} + \text{Cdcsx} + \text{Ctft})$$

Here, consider a case when a film of 300 nm thick having 7.5 of dielectric constant is used as the gate insulating film 15. A width of the scan line 101 and the storage capacitor line 102 is 10 μm and a width of the data line 3 is 10 μm. While the capacitance of the TFT section is determined by a channel width and a channel length, it is considered to be 0.01 pF. A number of scan lines crossing with the data line is 1,500. Therefore, because Cdgx = 0.0256 pF, Cdcsx = 0.0256 pF, Ctft = 0.01 pF and Ngate = 1500, the line capacitance of the data line, Cd_line, becomes = 91.8 pF.

Although it is possible to reduce the above mentioned capacitance of the intersections by thickening the gate insulating film 15, a driving capability of the TFT switch 4 drops inversely proportional to that in such a case. Therefore, it becomes necessary to enlarge the size of the TFT switch 4, increasing its area.

US 6,323,490 B1 discloses an image detector which is a direct conversion type image detector having a matrix arrangement of sensor sections, each sensor section includes an X-ray/charge conversion film, a storage capacitor for storing signal charges generated by the conversion film and a signal read-out transistor. A protective diode is arranged to remove excessive charges from the storage capacitor and prevent dielectric breakdown of the signal reach transistor. A power supply line for the protective diode is formed parallel to a signal read line via an insolating film. The power supply line is formed on a layer different from that of the signal read line. Specifically, a first metal layer comprises a scan line and a gate of the signal read transistor, a second metal layer comprises source and drain of the transistor, a pixel electrode and a signal read line and said power supply line.

WO 2004/073067 A1 discloses an image pick-up device having a matrix of sensor portions including TFTs. A gate electrode is provided in a semi conductor layer. In each sensor section, a TFT is formed in an insulating layer above which there is provided a further insulating layer including a shielding electrode.

WO 2004/077098 discloses an X-ray detector system having an image detector, a signal processing section and a storage section as well as a display section.

In view of the problems described above, the present invention provides an image detector capable of improving the production yield of TFT arrays, and capable of reducing electronic noise and improving the image quality of detected images.

## SUMMERY OF THE INVENTION

According to the invention, there is provided an image detector, as defined by claim 1.

According to the invention, the scan lines, data lines and common lines are each formed by metal layers that are different from each other and that have been provided with respective insulating film therebetween, therefore the production yield of the TFT array may be improved. Furthermore, since electronic noise may be reduced, the image quality of detected images may be improved.

## BRIEF DESCRIPTION OF THE DRAWINGS

An exemplary embodiment of the present invention will be described in detail based on the following figures, wherein:

Fig. 1 is an equivalent circuit diagram of an image detector according to a first example not covered by the claims;

Fig. 2 is a section view showing a structure of one pixel unit of the radiation image detector of the first example;

Fig. 3 is a plan view showing the structure of one pixel unit of the radiation image detector of the first example;

Fig. 4 is a view for explaining the steps for fabricating the radiation image detector of the first example;

Fig. 5 is a section view showing a structure of one pixel unit of a radiation image detector of an embodiment of the invention;

Fig. 6 is a plan view showing the structure of one pixel unit of the radiation image detector of the embodiment of the invention;

Fig. 7 is a view for explaining the steps for fabricating the radiation image detector of the embodiment of the invention;

Fig. 8 is a plan view showing a structure of one pixel unit of a modified example of the radiation image detector of the embodiment of the invention;

Fig. 9 is a section view showing a structure of one pixel unit of the modified example of the radiation image detector of the embodiment of the invention;

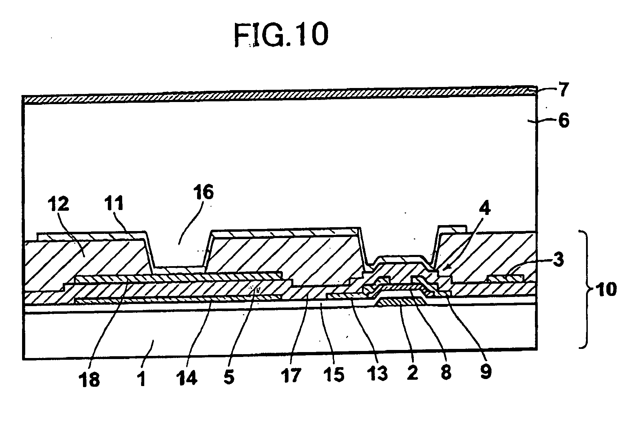

Fig. 10 is a section view showing a structure of one pixel unit of the modified example of the radiation image detector of the embodiment of the invention;

Fig. 11 is a plan view showing a structure of one pixel unit of the modified example of the radiation image detector of the embodiment of the invention;

Fig. 12 is a section view showing a structure of one pixel unit of the modified example of the radiation image detector of the embodiment of the invention;

Fig. 13 is a plan view showing a structure of one pixel unit of the modified example of the radiation image detector of the embodiment of the invention;

Fig. 14 is a section view showing a structure of one pixel unit of the image detector of a further example not covered by the claims.

Fig. 15 is a plan view showing a structure of one pixel unit of a modified example;

Fig. 16 is a view for explaining the steps for fabricating the radiation image detector of the further example;

Fig. 17 is a plan view showing a structure of one pixel unit of a modified example;

Fig. 18 is a section view showing a structure of one pixel unit of the modified example;

Fig. 19 is a schematic block diagram of a radiation detecting system of the invention;

Fig. 20 is a schematic circuit diagram of a conventional art radiation image detector;

Fig. 21 is a section view showing a structure of one pixel unit of a conventional art radiation image detector;

Fig. 22 is a plan view showing a structure of one pixel unit of the conventional art radiation image detector; and

Fig. 23. is an equivalent circuit diagram of the image detector of the embodiment of the invention.

## DETAILED DESCRIPTION OF THE INVENTION

A radiation image detector to which one example of an image detector not covered by the invention is applied will be explained below with reference to the drawings.

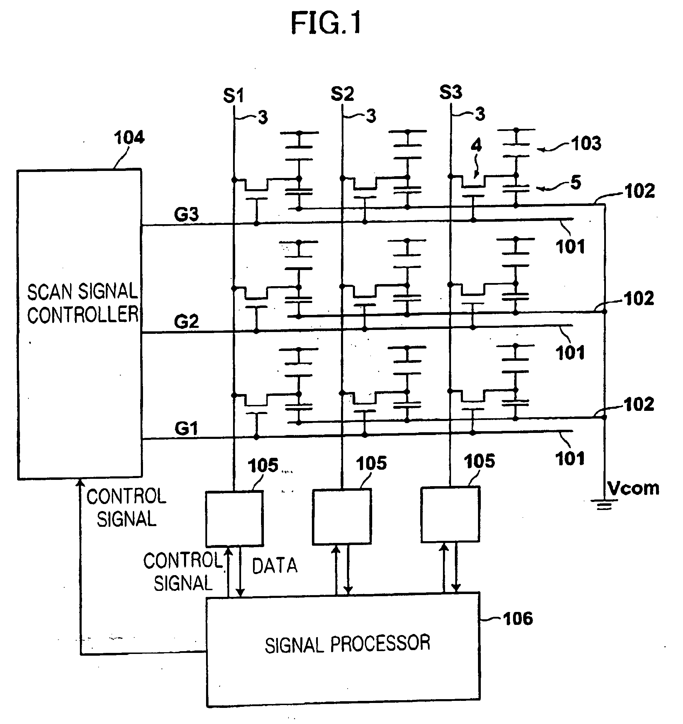

Fig. 1 is an equivalent circuit of the radiation image detector according to this example.

The radiation image detector of the example includes a large number of pixels arrayed two-dimensionally, each composed of an image sensor section 103 composed of a bias electrode, a semiconductor film and a charge collecting electrode as described later, a charge storage capacitor 5 for storing charge signals detected by the image sensor section 103 and a thin film transistor (referred to as a "TFT transistor" hereinafter) 4 for reading charges stored in the charge storage capacitor 5. Still more, there are provided a large number of scan lines 101 for turning ON/OFF the TFT switch 4 and a large number of data lines 3 for reading the charges stored in the charge storage capacitor 5. Furthermore, a storage capacitor line 102 is connected to one electrode of each of the charge storage capacitor 5.

Then, each data line 3 is connected with a signal detector 105 for detecting the charges flown out to each data line as an electrical signal and each scan line 101 is connected with a scan signal controller 104 for outputting a control signal for turning ON/OFF the TFT switch 4. Then, each signal detector 105 and the scan signal controller 104 are connected with a signal processor 106 for implementing a predetermined process to the electrical signal detected by each signal detector 105 and for outputting a control signal indicating timing for detecting the signal to each signal detector 105 and the scan signal controller 104 and a control signal indicating timing for outputting a scan signal.

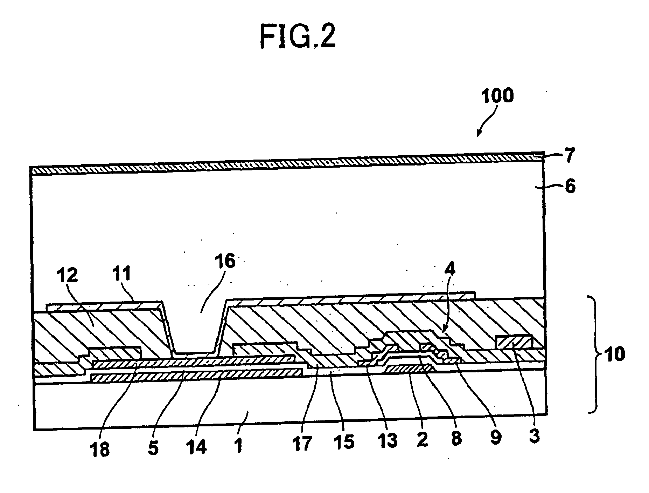

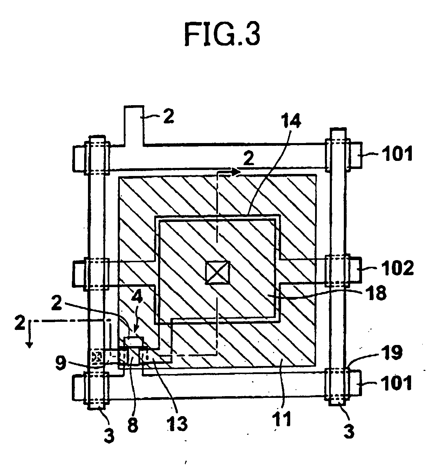

Here, the radiation image detector 100 of the example will be explained in detail. Fig. 2 is a section view showing a structure of one pixel unit of the radiation image detector 100 of this example. Fig. 3 is a plan view thereof. Fig. 2 is a section view along a line 2-2 in Fig. 3.

As shown in Fig. 2, a semiconductor film 6 having an electromagnetic wave conductivity and a bias electrode 7 connected to a high voltage source not shown are formed sequentially on the active matrix substrate 10 in the radiation image detector 100 of this example. The semiconductor film 6 generates electric charges (electrons - positive holes) therein when it is irradiated by electromagnetic waves such as X-rays. That is, the semiconductor film 6 has the electromagnetic wave conductivity and converts image information of the X-rays into electric charge information. The semiconductor film 6 is made of amorphous selenium (a-Se) whose main component is selenium for example. Here, the 'main component' means to have a content of 50 % or more.

The active matrix substrate 10 will be explained in detail below.

The active matrix substrate 10 has a glass substrate 1, a gate electrode 2, a storage capacitor lower electrode 14, a gate insulating film 15, a semiconductor layer 8, a source electrode 9, a drain electrode 13, a storage capacitor upper electrode 18, an insulation protecting film 17, a data line 3, an interlayer insulating film 12 and a charge collecting electrode 11. It is noted that although not shown in Fig. 2, the gate electrode 2 is connected with the scan line 101 as shown in Fig. 3 and the gate electrode 2 and the scan line 101 are formed by the same metal layer. Still more, the storage capacitor lower electrode 14 is connected with the storage capacitor line 102 and the storage capacitor lower electrode 14 and the storage capacitor line 102 are formed by the same metal layer as shown in Fig. 3.

The TFT switch 4 is constructed by the gate electrode 2, the gate insulating film 15, the source electrode 9, the drain electrode 13, the semiconductor layer 8 and others. The charge storage capacitor 5 is constructed by the storage capacitor lower electrode 14, the gate insulating film 15, the storage capacitor upper electrode 18 and others.

The glass substrate 1 is a supporting substrate and a non-alkaline glass substrate, e.g., Coning #1737, may be used for the glass substrate 1. The scan lines 101 and the data lines 3 are electrode lines arrayed in grid and the TFT switch 4 is formed at their intersection as shown in Fig. 3. The TFT switch 4 is a switching element whose source electrode 9 is connected to each of the data lines 3 via a contact hole and whose drain electrode 13 is connected to the storage capacitor upper electrode 18.

The gate insulating film 15 is made of SiNx, SiOx or others. The gate insulating film 15 is provided so as to cover the gate electrode 2, the scan line 101, the storage capacitor lower electrode 14 and the storage capacitor line 102 and a region thereof located on the gate electrode 2 operates as a gate insulating film in the TFT switch 4 and a region thereof located on the storage capacitor lower electrode 14 operates as a dielectric layer in the charge storage capacitor 5. That is, the charge storage capacitor 5 is formed by a region where the storage capacitor lower electrode 14 formed in the same layer with the gate electrode 2 is superimposed with the storage capacitor upper electrode 18.

The semiconductor layer 8 is a channel portion of the TFT switch 4 and is a passage of electric current connecting the source electrode 9 connected to the data line 3 with the drain electrode 13 connected to the storage capacitor upper electrode 18.

The insulation protecting film 17 is formed substantially across the whole area (substantially whole region) of the glass substrate 1. Thereby, it protects and electrically insulates the drain electrode 13 and the source electrode 9. The insulation protecting film 17 has a contact hole 16 at a region located on a portion facing to the storage capacitor lower electrode 14.

The charge collecting electrode 11 is made of an amorphous transparent conductive oxide film. The charge collecting electrode 11 is formed so as to bury the contact hole 16 and is deposited on the source electrode 9, the drain electrode 13 and the storage capacitor upper electrode 18. The charge collecting electrode 11 electrically conducts with the semiconductor film 6 and can collect electric charges generated in the semiconductor film 6.

The interlayer insulating film 12 is made of an acrylic resin having a photosensitivity and electrically insulates the TFT switch 4. The contact hole 16 penetrates through the interlayer insulating film 12 and the charge collecting electrode 11 is connected with the storage capacitor upper electrode 18 through the contact hole 16.

The gate electrode 2, the scan line 101, the storage capacitor lower electrode 14 and the storage capacitor line 102 are provided on the glass substrate 1. The semiconductor layer 8 is formed above the gate electrode 2 via the gate insulating film 15. The source and drain electrodes 9 and 13 are formed on the semiconductor layer 8. The storage capacitor upper electrode 18 is layered above the layers composing the charge storage capacitor 5. An insulation protecting film is disposed above the storage capacitor upper electrode 18, the source and drain electrodes 9 and 13.

The data line 3 is disposed on the insulation protecting film 17. Then, the interlayer insulating film 12 is provided above the insulation protecting film 17 and the data line 3. The charge collecting electrode 11 is provided in an upper layer of the interlayer insulating film 12, i.e., on the uppermost layer of the active matrix substrate 10. The charge collecting electrode 11 is connected with the TFT switch 4 via the storage capacitor upper electrode 18 and the drain electrode 13.

A high voltage source not shown is connected between the bias electrode 7 and the storage capacitor lower electrode 14.

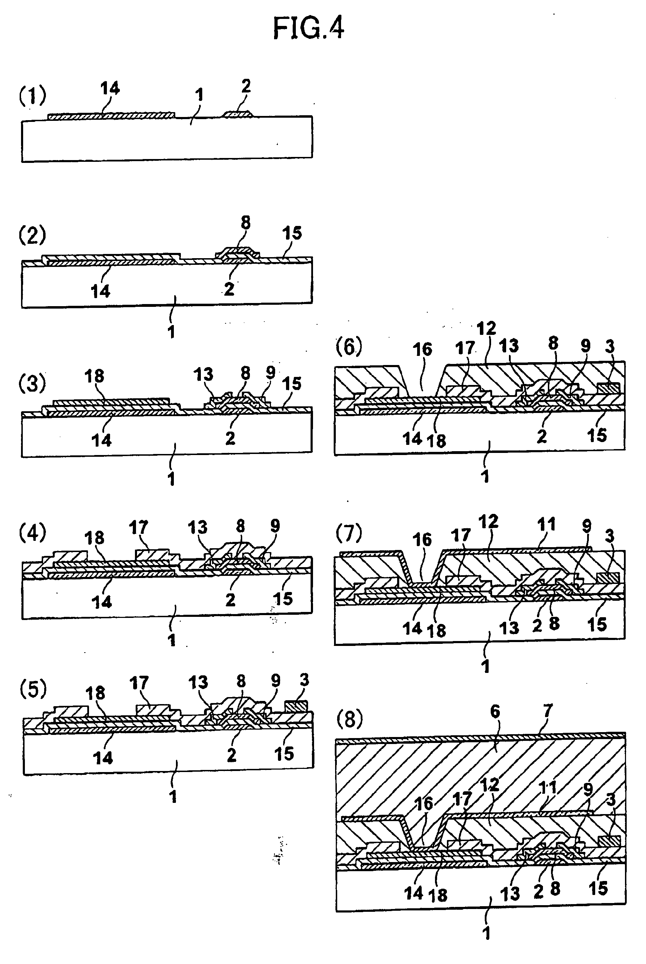

One exemplary manufacturing step of the radiation image detector of the example will be explained with reference to Fig. 4.

At first, the gate electrode 2, the scan line 101, the storage capacitor lower electrode 14 and the storage capacitor line 102 are formed as a gate line layer on the glass substrate 1 (1). The gate line layer is formed by low resistance metals such as Al or Al alloys, or layered films of low resistance metals and barrier metals with high melting point, or a single film of high melting point metals such as Mo. It has a thickness of around 100 to 300 nm and is deposited on the glass substrate 1 by sputtering. Then, patterning of a resist film is carried out by photolithography. After that, the metal film is patterned by wet etching by etchant for Al or by dry etching. Then, the gate line layer is completed by removing the resist.

Next, the gate insulating film 15, the semiconductor layer (amorphous silicon layer) 8 and an impurity doped semiconductor layer (not shown) are sequentially deposited on the gate line layer (2). The gate insulating film 15 is made of SiNx and its thickness is 200 to 600 nm. The semiconductor layer 8 is made of an amorphous silicon layer and its thickness is around 20 to 100 nm. The impurity doped semiconductor layer is made of an impurity doped amorphous silicon layer and its thickness is around 10 to 50 nm. These are deposited by a P-CVD method. After that, patterning of a resist is carried by the photolithography in the same manner with the gate line layer. Then, a semiconductor active region is formed by dry etching the semiconductor layer 8 and the impurity doped semiconductor layer selectively with respect to the gate insulating film.

Next, the source electrode 9, the drain electrode 13 and the storage capacitor upper electrode 18 are formed (3). A source line layer is deposited on an upper layer of the gate insulating film 15 and the semiconductor layer 8. The source line layer is a metal film, similarly to the gate line layer, which is formed by low resistance metals made of Al or Al alloys, or layered films of low resistance metals and barrier metals with high melting point, or a single film of high melting point metals such as Mo. Its thickness is around 100 to 300 nm. Patterning is carried out by the photolithography in the same manner with the case of the gate line layer to pattern the metal film by the wet etching by means of the etchant for Al or by dry etching. At this time, the gate insulating film is not removed. After that, the impurity doped semiconductor layer and the semiconductor layer 8 are partially removed by the dry etching to form a channel region.

The insulation protecting film 17 is deposited on the layers formed as described above (4). The insulation protecting film 17 is made of an inorganic material such as SiNx and $SiO_2$ and is deposited by the P-CVD method. Its thickness is around 200 to 600 nm. Then, patterning of the contact hole is carried out by the photolithography similarly to the case of the gate line layer and the insulation protecting film 17 is selectively patterned by the dry etching.

Next, the data line 3 is formed (5). The data line 3 (layer) is formed on the insulation protecting film 17. This layer is a metal film, similarly to the case of the gate line layer, which is formed by low resistance metals made of Al or Al alloys, or layered films of low resistance metals and barrier metals with high melting point., or a single film of high melting point metals such as Mo. Its thickness is around 100 to 400 nm. Patterning is carried out by the photolithography in the same manner with the case of the gate line layer to pattern the metal film by the wet etching by means of the etchant for Al or by dry etching. At this time, the gate insulating film is not removed.

Next, the interlayer insulating film 12 is deposited on the layers formed as described above (6). The interlayer insulating film is made of an inorganic material such as SiNx and $SiO_2$ or of an organic insulating film material such as SOG and an acrylic resin. Generally, the organic insulating film material is preferable because it has the effect of reducing the capacitance between the data line and the charge collecting electrode because it has a low dielectric constant and is readily thickened. In case of the photosensitive organic insulating film material, the material is applied by spinning into a thickness of around 1 to 3 $\mu$m. Then, patterning of the contact hole 16 is carried out by the photolithography. The interlayer insulating film 12 is completed by patterning by using dedicated etchant and by baking it. When the material is not the photosensitive material, the contact hole is formed by implementing dry etching after a photolithographic process similarly to other layers. It is noted that a size of the contact hole 16 is preferable to be smaller than 10 $\mu$m squares. When the contact hole 16 is large, crystallization occurs by a stepped portion after forming the semiconductor film 6.

Next, the charge collecting electrode 11 is formed (7). A transparent electrode material such as ITO is deposited by sputtering on the layers formed as described above. Its thickness is around 20 to 200 nm. Then, patterning is carried out by the photolithography and the electrode is patterned by wet etching by etchant for ITO or by dry etching. At this time, the underlying interlayer insulating film is not damaged by adopting the etching selectively.

Next, the semiconductor film 6 and the bias electrode 7 are formed (8). The semiconductor film 6 made of a-Se and having the electromagnetic wave conductivity is formed into a thickness of 0.5 mm to 1.5 mm for the use of general radiography for medical diagnoses by a vacuum evaporation method on the layers formed as described above. Then, finally, the bias electrode 7 made of Au, Al or others is formed substantially on the whole surface of the semiconductor film 6 into a thickness of about 100 nm by the vacuum evaporation.

Next, the principle of operation of the radiation image detector having the abovementioned structure will be explained. When X-rays are irradiated to the semiconductor film 6 while applying a voltage between the bias electrode 7 and the storage capacitor lower electrode 14, the semiconductor film 6 generates electric charges (pairs of electron - positive hole) therein. Then, because the semiconductor film 6 is arranged to be electrically connected with the charge storage capacitor 5 in series, electrons generated within the semiconductor film 6 move to the side of + electrode and positive holes move to the side of - electrode. As a result, electric charges are stored in the charge storage capacitor 5.

It is then possible to take out the charges stored in the charge storage capacitor 5 to the outside via the data line 3 by turning ON the TFT switch 4 by an input signal to the scan line 101.

Then, because the scan line 101, the data line 3, the TFT switch 4 and the charge storage capacitor 5 are all provided in matrix of X and Y, it is possible to obtain image information of the X-rays two dimensionally by sequentially scanning the signals inputted to the scan line 101 and by detecting signals from each data line 3.

In the radiation image detector 100 of the example as shown in Fig. 2, the data line 3 is formed in the upper layer of the source and drain electrodes 9 and 13 via the insulation protecting film 17. Therefore, the gate insulating film 15 and the insulation protecting film 17 exist at the intersection of the data line 3 with the scan line 101 and at the intersection of the data line 3 with the storage capacitor line 102. Accordingly, the line capacitance of the data line 3 may be reduced. Meanwhile, only the gate insulating film 15 exists at the charge storage capacitor 5 and the TFT switch 4, so that it is possible to prevent an electrode area of the storage capacitor from expanding and a TFT driving capability from dropping.

Furthermore, in the TFT switch production process, leakage frequently occurs between the gate line layer and the source line layer due to electrostatic breakdown. When the structure of the radiation image detector of the example is adopted, the insulating film between the source and gate electrodes of the TFT switch is thinner than that of the intersection of the data line with the scan line, so that a withstand voltage is set low. Thereby, even when the failure of leak occurs due to the static electricity, there is a high probability that it becomes a failure of leak of the TFT switch. Although it becomes a failure of lines when the failure of leak occurs between the lines, it is possible to end as a failure of a single pixel when a failure of leak occurs in the TFT switch by disconnecting the TFT switch. Normally, the radiation image detector may be improved by generating information on a defective pixel from data of neighboring pixels and by compensating an image. However, it is difficult to correct the image by interpolation of images in case of the failure of lines. Accordingly, it is possible to improve a production yield by avoiding the failure of lines as described above.

Still more, it is preferable to increase the thickness of the data line because its resistance needs to be lowered. That is, it is desirable to thicken the metal layer of the data line more than the metal layer of the source and drain electrodes. The thickness of the metal layer is limited because an accuracy of patterning drops when the source and drain electrodes are formed in the same layer and when its thickness increases. However, according to the radiation image detector of the example, the data line is formed in the layer different from the source electrode and the drain electrode, so that it becomes possible to increase the thickness of the data line and to realize a low resistant data line, reducing the noise of the data line. Further, production process time may be reduced since the thickness of the metal layer of the source electrode and the drain electrode may be made thin.

Next, the line capacitance of the data line of the radiation image detector of the example will be explained by using specific numerical values.

As described above, the line capacitance of the data line Cd_line may be expressed as follows:

$$Cd\_line \fallingdotseq Ngate \times (Cdgx + Cdcsx + Ctft)$$

Here, SiNx is used as the gate insulating film 15 and its thickness is 300 nm and its dielectric constant is 7.5. Meanwhile, SiNx is used also for the insulation protecting film 17 and its thickness is 300 nm and its dielectric constant is 7.5. A line width of the scan line 101 and the storage capacitor line 102 is 10 $\mu$m and a line width of the data line 3 is 10 $\mu$m. While the capacitance of the TFT section is determined by a channel width W and a channel length L, one having 0.01 pF is used this time. A number of gate lines is 1,500. Then, in a conventional structure, because Cdgx = 0.0256 pF, Cdcsx = 0.0256 pF, Ctft = 0.01 pF and Ngate = 1500, the line capacitance of the data line, Cd_line, becomes = 91.8 pF. In contrast, in the structure of the radiation image detector of the example, Cdgx = 0.0096 pF, Cdcsx = 0.0096 pF, so that the line capacitance of the data line, Cd_line, is = 43.8 pF. Accordingly, the line capacitance of the data line may be reduced to 48 % and the electronic noise may be reduced accordingly.

It is noted that in the radiation image detector of this example, a semiconductor layer 19 may be provided between the gate insulating film 15 and the insulation protecting film 17 at the intersection of the data line 3 with the scan line 101 as shown in Fig. 3. It becomes possible to reduce the capacitance of the intersection of the data line 3 with the scan line 101 further by constructing as described above. Furthermore, because it is possible to prevent a reduction of the gate insulating film 15 by etching of the semiconductor layer and the source electrode layer by providing the semiconductor layer 19, it is possible to reduce the electronic noise because the remaining film of the gate insulating film 15 is thick and a low capacitance may be realized.

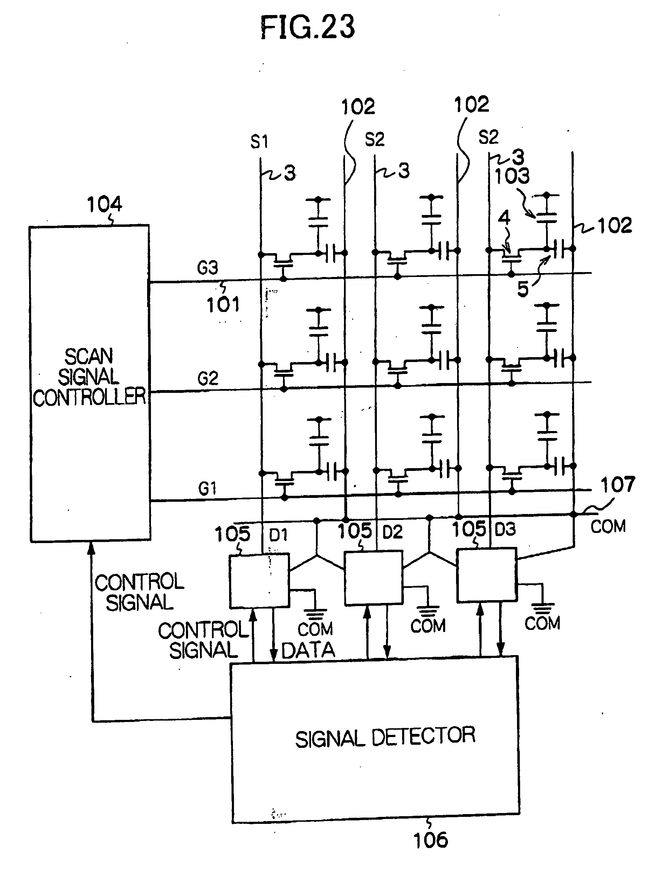

Next, a radiation image detector 200 of an embodiment of the invention will be explained. Fig. 23 is an equivalent circuit of the radiation image detector 200 of the embodiment.

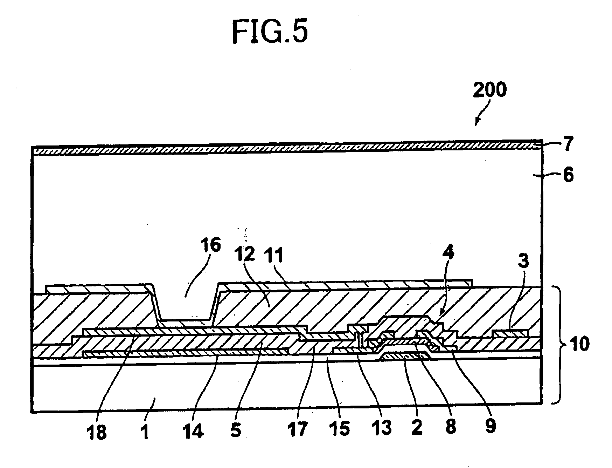

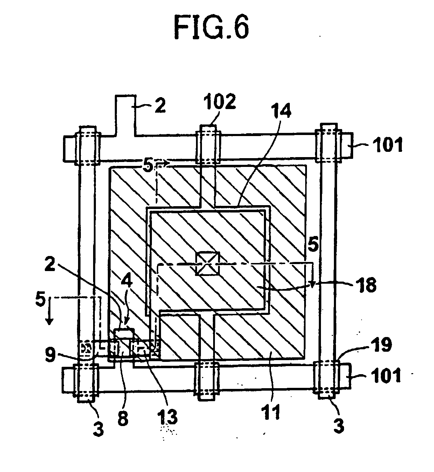

Fig. 5 is a section view showing a structure of one pixel unit of the radiation image detector 200 of the embodiment and Fig. 6 is a plan view thereof. Fig. 5 is a section view along a line 5-5 in Fig. 6.

The radiation image detector 200 of the embodiment is different from the , radiation image detector of the example in the positions of the storage capacitor lower electrode 14, the storage capacitor line 102 and the position of the storage capacitor upper electrode 18. Then, the storage capacitor line 102 of the radiation image detector 200 of the embodiment is disposed in parallel with the data line 3 as shown in Fig. 23 and Fig. 6. The storage capacitor line 102 is connected with a line 107 on the outside of a region of the sensor array section where the image sensor section 103 is provided per a predetermined number of lines. The line 107 is connected the respective signal detectors 105. A predetermined voltage Vcom is applied from the signal detector 105 to each of the storage capacitor line 102 via the line 107. It is noted that Fig. 23 is simplified by connecting each of the storage capacitor lines 102 to one line 107. The other components are the same with those of the example.

As shown in Fig. 5, the gate electrode 2 and the scan line 101 are provided on the glass substrate 1 of the radiation image detector 200 of the embodiment. The gate insulating film 15 is provided above the gate electrode 2 and the scan line 101. The semiconductor layer 8 is formed above the gate electrode 2 via the gate insulating film 15. The source and drain electrodes 9 and 13 are formed on the semiconductor layer 8. Then, the storage capacitor lower electrode 14 and the storage capacitor line 102 are formed in the same metal layer with the source and drain electrodes 9 and 13. Then, the insulation protecting film 17 is formed above the source electrode 9, the drain electrode 13, the storage capacitor lower electrode 14 and the storage capacitor line 102.

The data line 3 is disposed on the insulation protecting film 17 and the storage capacitor upper electrode 18 is formed in the same metal layer with the data line 3. Then, the interlayer insulating film 12 is provided above the storage capacitor upper electrode 18 and the data line 3. The charge collecting electrode 11 is provided in an upper layer of the interlayer insulating film 12. The charge collecting electrode 11 is connected with the TFT switch 4 via the storage capacitor upper electrode 18 and the drain electrode 13.

The charge collecting electrode 11 is also connected with the storage capacitor upper electrode 18 by the contact hole 16 that penetrates through the interlayer insulating film 12. It is noted that the size of the contact hole 16 is preferable to be smaller than 10 μm squares. When the contact hole 16 is large, crystallization occurs by the stepped portion after forming the semiconductor film 6.

The storage capacitor upper electrode 18 is also connected with the drain electrode 13 by the contact hole.

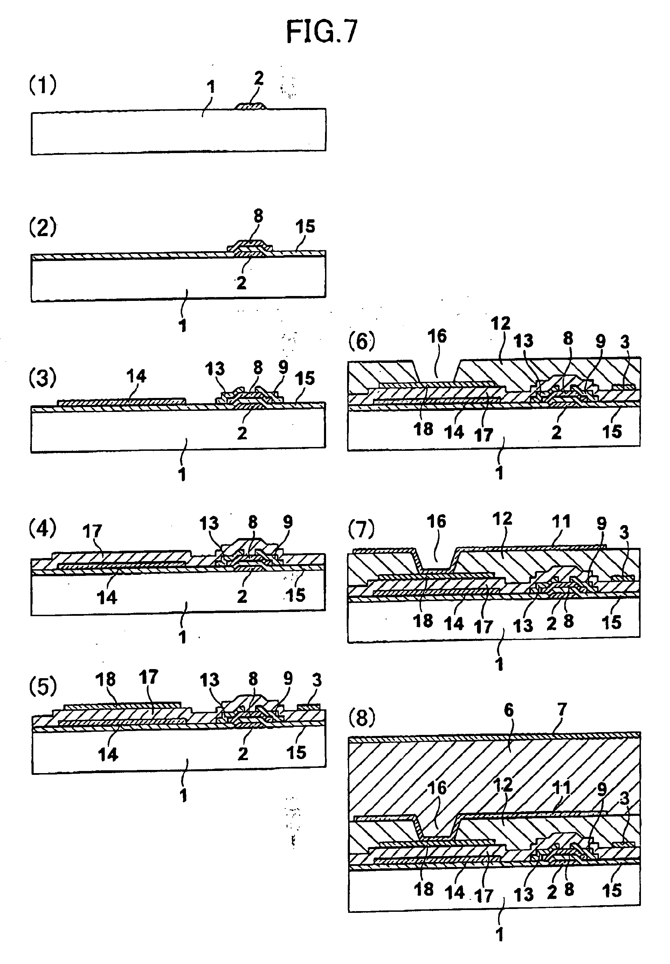

One exemplary manufacturing step of the radiation image detector of the embodiment will be explained below with reference to Fig. 7. It is noted that the detail of the manufacturing step and the materials of the radiation image detector of the embodiment are the same with the radiation image detector of the example.

The gate electrode 2 and the scan line 101 are formed as the gate line layer on the glass substrate 1 at first (1). Next, the gate insulating film 15, the semiconductor layer 8 and the impurity added semiconductor layer (not shown) are sequentially deposited on the gate line layer (2). Then, the source electrode 9, the drain electrode 13, the storage capacitor lower electrode 14 and the storage capacitor line 102 are formed (3). Next, the insulation protecting film 17 is deposited on the layers formed as described above (4). Next, the data line 3 and the storage capacitor upper electrode 18 are formed (5). Then, the interlayer insulating film 12 is deposited on the layers formed as described above (6). Then, the charge collecting electrode 11 is formed (7) and the semiconductor film 6 and the bias electrode 7 are formed thereon (8).

Similarly to the radiation image detector 100 of the example, the data line 3 is formed in the upper layer of the source and drain electrodes 9 and 13 via the insulation protecting film 17 in the radiation image detector 200 of the embodiment. Therefore, the gate insulating film 15 and the insulation protecting film 17 exist at the intersection of the data line 3 with the scan line 101 and at the intersection of the data line 3 with the storage capacitor line 102. Accordingly, the line capacitance of the data line 3 may be reduced. Meanwhile, only the gate insulating film 15 exists at the charge storage capacitor 5 and the TFT switch 4, so that it is possible to prevent the electrode area of the storage capacitor from expanding and the TFT driving capability from dropping.

Furthermore, the insulating film between the source and gate electrodes of the TFT switch is thinner than that of the intersection of the data line with the scan line similarly to that of the radiation image detector 100 of the example, so that a withstand voltage is set low. Thereby, even when a failure of leak occurs due to static electricity, there is a high probability that it becomes a failure of leak of the TFT switch. Although it becomes a failure of lines when the failure of leak occurs between the lines, it is possible to end as a failure of a single pixel when a failure of leak occurs in the TFT switch by disconnecting the TFT switch. Normally, the radiation image detector may be improved by generating information on a defective pixel from data of neighboring pixels and by compensating an image. However, it is difficult to correct the image by interpolation of images in many times in case of the failure of lines. Accordingly, it is possible to improve a production yield by avoiding the failure of lines as described above.

Furthermore, the storage capacitor line 102 is formed in a separate layer of metallic material from that of the scan line 101, with gate insulating film 15 therebetween, and formed in a separate layer of metallic material from that of the data lines 3, with the insulation protecting film 17 therebetween. By so doing, if patterning defects occur during formation of the storage capacitor line 102, even if there are the remains of a conductive material film, leakage do not occur with the scan line 101 and the data lines 3. Thereby, the production yield of the TFT array of the image detector is greatly improved, and hence this configuration is particularly effective for the manufacture of high precision image detector TFT arrays (pixel pitch of < 200 $\mu$m). For example, if the pixel pitch is 200 $\mu$m, the data lines 3 line width is 10 $\mu$m, and the storage capacitor line 102 line width is 10 $\mu$m, then the gap between lines is only 90 $\mu$m (in addition, for example, if the storage capacitor upper electrode 18 of the charge storage capacitor 5 or the storage capacitor lower electrode 14 are formed in the same layer, and if, say, the width of the storage capacitor upper electrode 18 or the storage capacitor lower electrode 14 is 10 $\mu$m, then the gap between lines is only 40 $\mu$m). However, by forming the storage capacitor line 102, the scan line 101 and the data lines 3 in separate layers, even if there are patterning defects that occur when forming the lines and there are the remains of a conductive material film, leakage do not occur between the storage capacitor line 102 and the data lines 3.

Furthermore, the storage capacitor line 102 is formed in a lower layer to that of the semiconductor film 6. By so doing, the lines of the storage capacitor line 102 are formed in a prior step/process to that for forming the semiconductor film 6, and the productivity of the production line for manufacturing the radiation image detector 100 may be improved.

That is to say, in the radiation image detector 100, in order to maintain sufficient detection sensitivity it is necessary to form the semiconductor film 6 as a thicker film compared to other layers on the active matrix substrate 10. For example, in the present embodiment, the semiconductor film 6 is vacuum deposited as a 0.5 mm to 1.5 mm thick a-Se film. The deposition process for forming such a semiconductor film 6 requires a long processing time, and incurs a high production cost. With regard to this, the semiconductor film 6 is only formed on the active matrix substrates 10 that have completed the forming of the main line layers below the semiconductor film 6, and that have been determined to be of good quality by image inspection at each of the processes, and by continuity tests and the like. In this manner, the number of wafers that are processed in the inherently low productivity deposition process for the semiconductor film 6 layer may be reduced, and the overall productivity improved.

Still more, it is possible to increase the thickness of the data line 3, to realize the low resistant data line and to reduce the data line noise in the same manner with the radiation image detector 100 of the example. In other words, it is desirable to increase the thickness of the metal layer of the data line so that it is more than the thickness of the metal layer of the source and drain electrodes.

Furthermore, since intersections of the storage capacitor line 102 with the data lines 3 disappear as a result of disposing the storage capacitor line 102 parallel to the data lines 3, the capacitance of the intersections of the storage capacitor line 102 with the data lines 3 may be reduced, and further electronic noise reduction may be made.

Furthermore, because the charge storage capacitor 5 is composed of the storage capacitor lower electrode 14, the insulation protecting film 17 and the storage capacitor upper electrode 18, the charge storage capacitor 5 may be constructed by the insulating film different from the gate insulating film 15 composing the TFT switch 4. When the charge storage capacitor 5 is constructed by the gate insulating film 15 and when the gate insulating film 15 is thinned to increase ON current of the TFT switch 4, the storage capacitance of the charge storage capacitor 5 also increases proportionally. However, because the storage capacitance of the charge storage capacitor 5 does not increase even when the gate insulating film 15 is thinned in the radiation image detector of the embodiment, it is possible to shorten a charge transfer time of the pixel. As a result, it becomes possible to design an ideal sensor element and to reduce the electronic noise.

Next, the line capacitance of the data line of the radiation image detector of the embodiment will be explained by using specific numerical values.

As described above, the line capacitance of the data line Cd_line may be expressed as follows:

$$Cd\_line \fallingdotseq Ngate \times (Cdgx + Cdcsx + Ctft)$$

Here, SiNx is used as the gate insulating film 15 and its thickness is 300 nm and its dielectric constant is 7.5. Meanwhile, SiNx is used also for the insulation protecting film 17 and its thickness is 500 nm and its dielectric constant is 7.5. A width of the scan line 101 and the storage capacitor line 102 is 10 $\mu$m and a width of the data line 3 is 10 $\mu$m.

While the capacitance of the TFT section is determined by a channel width W and a channel length L, one having 0.01 pF is adopted this time. A number of gate lines is 1,500. Then, in a conventional structure, because Cdgx = 0.0256 pF, Cdcsx = 0.0256 pF, Ctft = 0.01 pF and Ngate = 1500, the line capacitance of the data line, Cd_line, becomes = 91.8 pF. In contrast, in the structure of the radiation image detector of the second exemplary embodiment, Cdgx = 0.0096 pF, Cdcsx = 0 pF (because there is no intersection of the data line and the storage capacitor line), so that the line capacitance of the data line, Cd_line, becomes = 29.4 pF. Accordingly, the line capacitance of the data line may be reduced to 32 % and the electronic noise may be reduced accordingly.

It is noted that the semiconductor layer 19 may be provided between the gate insulating film 15 and the insulation protecting film 17 at the intersection of the data line 3 with the scan line 101 as shown in Fig. 6 also in the radiation image detector of the embodiment.

It is possible to lower the capacitance of the intersection of the data line 3 with the scan line 101 further by arranging as described above.

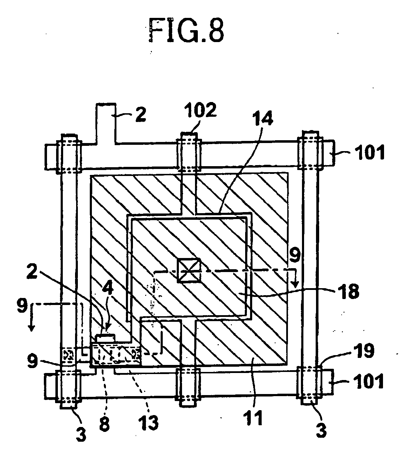

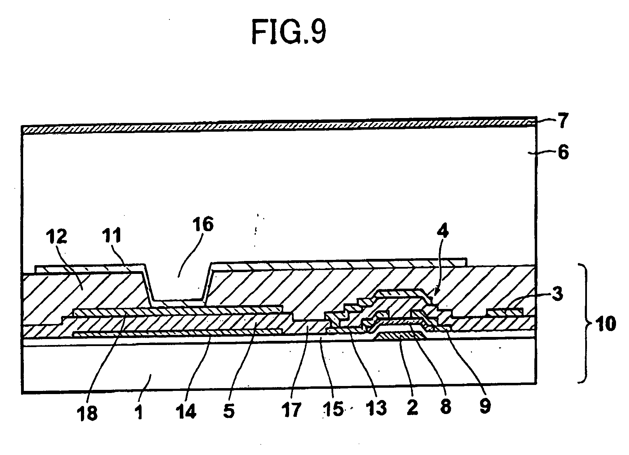

Furthermore, the storage capacitor upper electrode 18 may be extended so that it is disposed above the TFT switch 4 via the insulation protecting film 17 as shown in Fig. 8 in the radiation image detector of the embodiment. Fig. 9 is a section view along a line 9-9 in Fig. 8. For example, when the application to the bias electrode of the radiation image detector is a positive bias, the electric charges stored in the charge storage capacitor 5 becomes positive. However, it becomes possible to realize a structure by which the TFT switch 4 automatically turns ON when the stored charges become large by extending the storage capacitor upper electrode 18 connected with the charge collecting electrode 11 over the TFT switch 4 as shown in Fig. 8 and Fig. 9. Thereby, it becomes possible to avoid the pixel from being broken by the large stored charge.

Furthermore, it is also possible to arrange the radiation image detector of the second exemplary embodiment so that the interlayer insulating film above the TFT switch 4 is removed. Thereby, a threshold voltage that automatically turns ON the TFT switch 4 when the stored charges of the pixel become large may be lowered, so that it is possible to avoid the pixel from being broken more effectively.

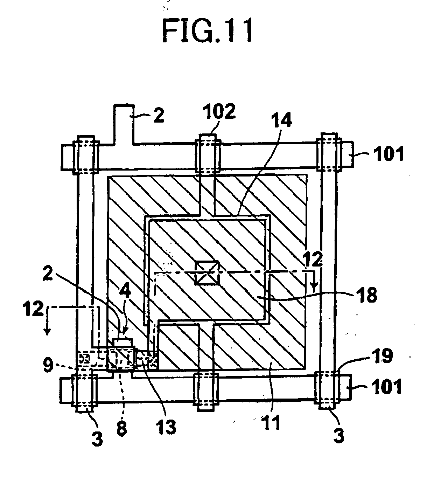

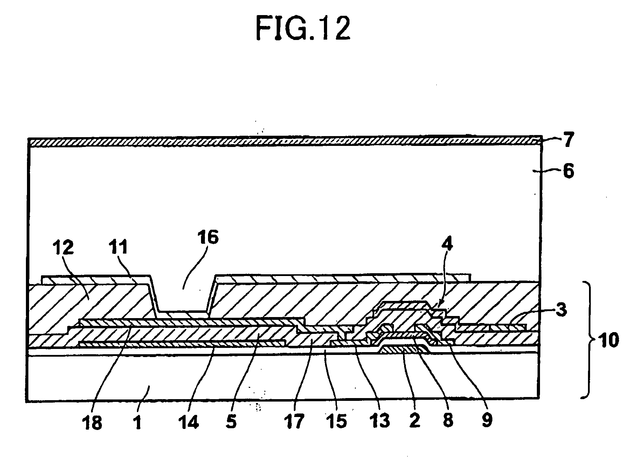

Still more, the data line 3 may be extended above the TFT switch 4 as shown in Fig. 11 in the radiation image detector of the embodiment. Fig. 12 is a section view along a line 12-12. It is possible to realize a shield structure to electric potential of the charge collecting electrode 11 by constructing as described above. For example, even if 100 V is applied to the charge collecting electrode 11, no electric field is applied to a back channel of the TFT switch 4 if the potential of the data line 3 is 0 V.

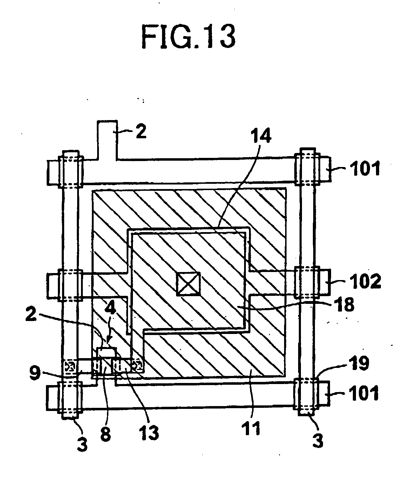

Furthermore, although the storage capacitor line 102 is disposed so as to run in parallel with the data line 3 in the radiation image detector of the embodiment, the storage capacitor line 102 may be provided so as to run in parallel with the scan line 101 as shown in Fig. 13. It is noted that the structure of layers and the manufacturing step are the same with the radiation image detector of the embodiment.

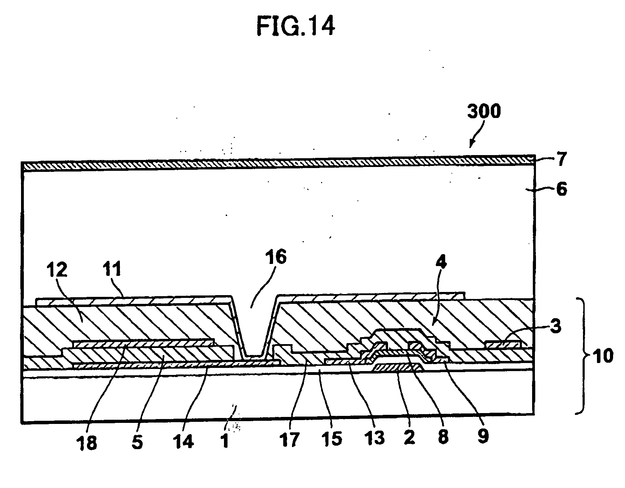

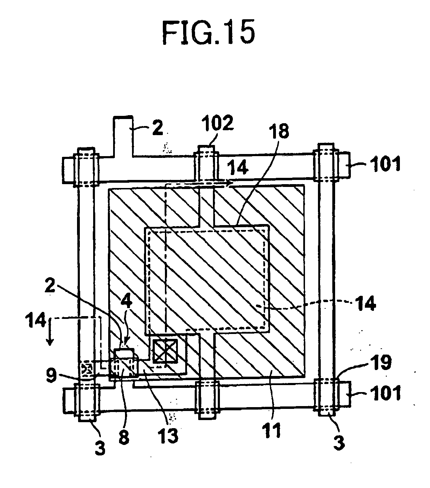

Next, a radiation image detector 300 of a further example not covered by the claims will be explained. Fig. 14 is a section view showing a structure of one pixel unit of the radiation image detector 300 of the further example and Fig. 15 is a plan view thereof. Fig. 14 is a section view along a line 14-44 in Fig. 15.

The radiation image detector 300 of the further example is different from the radiation image detector of the embodiment in that the position of the storage capacitor line 102 is different and that the charge collecting electrode 11 is connected to the storage capacitor lower electrode 14. The other components are the same with those of the embodiment.

The gate electrode 2 and the scan line 101 are provided on the glass substrate 1 of the radiation image detector 300 of the further example. The gate insulating film 15 is provided above the gate electrode 2 and the scan line 101 and the semiconductor layer 8 is formed above the gate electrode 2 via the gate insulating film 15. The source and drain electrodes 9 and 13 are formed on the semiconductor layer 8. Then, the storage capacitor lower electrode 14 is formed in the same metal layer with the source and drain electrodes 9 and 13. Then, the insulation protecting film 17 is formed above the source electrode 9, the drain electrode 13 and the storage capacitor lower electrode 14.

The data line 3 is disposed on the insulation protecting film 17. The storage capacitor upper electrode 18 and the storage capacitor line 102 are formed in the same metal layer with the data line 3. Then, the interlayer insulating film 12 is provided above the storage capacitor upper electrode 18, the data line 3 and the storage capacitor line 102. The charge collecting electrode 11 is provided in an upper layer of the interlayer insulating film 12. The charge collecting electrode 11 is connected with the TFT switch 4 via the storage capacitor lower electrode 14 and the drain electrode 13.

The charge collecting electrode 11 is also connected with the storage capacitor lower electrode 14 by the contact hole 16 that penetrates through the interlayer insulating film 12 and the insulation protecting film 17. It is noted that the size of the contact hole 16 is desirable to be smaller than 10 μm squares. When the contact hole 16 is large, crystallization occurs by the stepped portion after forming the semiconductor film 6.

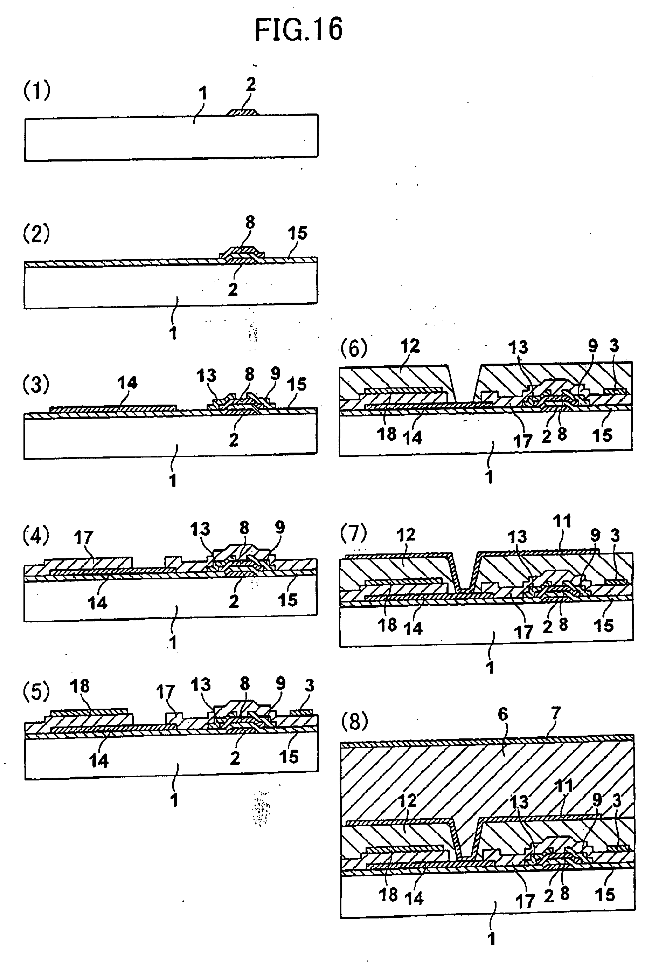

One exemplary manufacturing step of the radiation image detector of the further example will be explained below with reference to Fig. 16. It is noted that the detail of the manufacturing step and the materials of the radiation image detector of the further example are the same with the radiation image detector of the above example.

The gate electrode 2 and the scan line 101 are formed as the gate line layer on the glass substrate 1 at first (1). Next, the gate insulating film 15, the semiconductor layer 8 and the impurity added semiconductor layer (not shown) are sequentially deposited on the gate line layer (2). Then, the source electrode 9, the drain electrode 13 and the storage capacitor lower electrode 14 are formed (3). Next, the insulation protecting film 17 is deposited on the layers formed as described above (4). Next, the data line 3, the storage capacitor upper electrode 18 and the storage capacitor line 102 are formed (5). Then, the interlayer insulating film 12 is deposited on the layers formed as described above (6). Then, the charge collecting electrode 11 is formed (7) and the semiconductor film 6 and the bias electrode 7 are formed thereon (8).

It is possible to obtain basically the same effect with the radiation image detector 200 of the embodiment also in the radiation image detector 300 of the further example.

In the radiation image detector of the further example, the gate insulating film 15 and the insulation protecting film 17 are disposed also at the intersection of the storage capacitor line 102 with the scan line 101. Thereby, it is possible to reduce a line capacitance of the storage capacitor line 102 and the scan line 101.

Still more, the charge storage capacitor 5 is composed of two layers of the lower layer between the storage capacitor lower electrode 14 and the storage capacitor upper electrode 18, and the upper layer between the charge collecting electrode 11 and the storage capacitor upper electrode 18. Therefore, it is possible to increase the capacitance per unit area and to reduce an area of the storage capacitor upper electrode 18. A distance between the data line 3 and the storage capacitor upper electrode 18 may be widened when the area of the storage capacitor upper electrode 18 is small, so that it becomes possible to reduce the failure of leak.

Still more, because the charge storage capacitor 5 is composed of the storage capacitor lower electrode 14, the insulation protecting film 17 and the storage capacitor upper electrode 18, the charge storage capacitor 5 may be constructed by the insulating film different from the gate insulating film 15 that composes the TFT switch 4. When the charge storage capacitor 5 is composed of the gate insulating film 15 and when the gate insulating film 15 is thinned to increase the ON current of the TFT switch, the storage capacitance of the charge storage capacitor 5 also increase proportionally. In contrast, according to the radiation image detector of the embodiment, the storage capacitance of the charge storage capacitor 5 does not increase even when the gate insulating film 15 is thinned, so that a charge transfer time of the pixel may be shortened. As a result, it becomes possible to design an ideal sensor element and to reduce the electronic noise.

It is noted that although the case when the storage capacitor line 102 for applying bias voltage commonly to the storage capacitor lower electrode 14 of each of the charge storage capacitor 5 is disposed in parallel to the data line 3 has been explained as a common line in the radiation image detectors of the embodiment and further example and the case when the scan line 101, the data line 3 and the storage capacitor line 102 are formed by the metal layers that are provided via the insulating film and that differ from each other has been explained in the radiation image detector of the embodiment, the invention is not limited to them. For instance, when the bias electrode 7 is separately formed corresponding to each image sensor section 103 to apply bias voltage from each bias electrode 7 to the semiconductor film 6, it is possible to dispose the bias line for applying the bias voltage to each bias electrode 7 in parallel with the data line 3 and to form the bias line, the scan line 101 and the data line 3 by the metal layers that differ from each other via the insulating film.

The semiconductor layer 19 may be provided between the gate insulating film 15 and the insulation protecting film 17 at the intersection of the data line 3 and the scan line 101 as shown in Fig. 15 also in the radiation image detector of the further example. It becomes possible to reduce the capacitance of the intersection of the data line 3 and the scan line 10 further by constructing as described above.

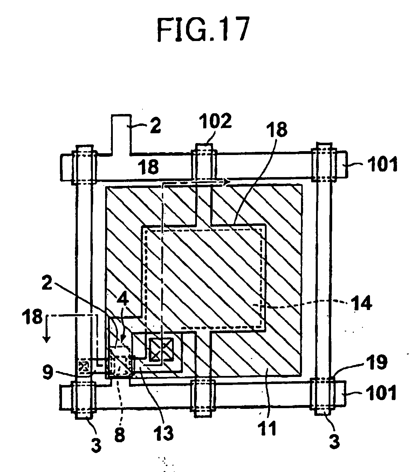

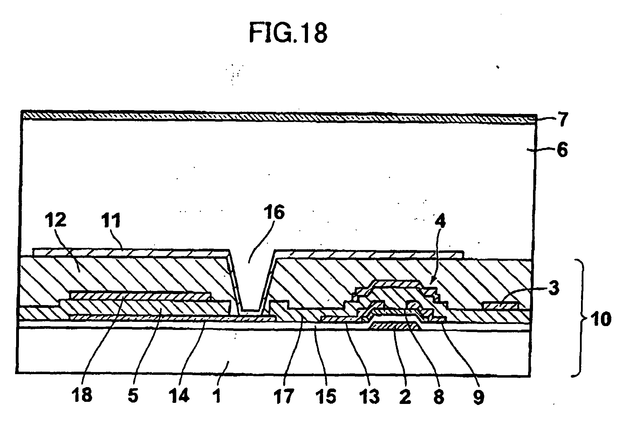

Further, the storage capacitor upper electrode 18 may be extended so as to dispose above the TFT switch 4 via the insulation protecting film 17 as shown in Fig. 17 also in the radiation image detector of the further example. Fig. 18 is a section view along a line 18-18 in Fig. 17. It becomes possible to realize a shield structure to the potential of the charge collecting electrode 11 by constructing as described above. For instance, even if 100 V is applied to the charge collecting electrode 11, no electric field is applied to the back channel of the TFT switch 4 if a potential of the data line 3 is 0 V.

Still more, it is desirable to thicken the thickness of the insulation protecting film 17 more than that of the gate insulating film 15 in the radiation image detector of the examples and the embodiment. Table 1 shows the materials of the gate insulating film 15 and the insulation protecting film 17 and an appropriate range, a more preferable range and an ideal value of the thickness and dielectric constant of the gate insulating film 15 and the insulation protecting film 17. It is desirable to thin the gate insulating film 15 to enhance the driving capability of the TFT switch 4 and to thicken the insulation protecting film 17 to reduce the line capacitance of the data line.

[Table 1]

| | | Appropriate Range | More Preferable Range | Ideal Value |
|---|---|---|---|---|
| Gate Insulating Film | Material | SiNx | SiNx | SiNx |
| | Thickness (nm) | 100 to 600 | 200 to 400 | 300 |
| | $\varepsilon r$ | 6 to 8 | 6 to 8 | 7 |
| Insulating Protection Film | Material | SiNx | SiNx | SiNx |
| | Thickness (nm) | 200 to 800 | 400 to 600 | 500 |
| | $\varepsilon r$ | 6 to 8 | 6 to 8 | 7 |

Still more, the dielectric constant of the insulation protecting film 17 is desirable to be lower than the dielectric constant of the gate insulating film 15 in the radiation image detector of the examples and the embodiment. Table 2 shows the materials of the gate insulating film 15 and the insulation protecting film 17 and an appropriate range, a more preferable range and an ideal value of the thickness and dielectric constant of the gate insulating film 15 and the insulation protecting film 17.

[Table 2]

| | | Appropriate Range | More Preferable Range | Ideal Value |
|---|---|---|---|---|
| Gate Insulating Film | Material | SiNx | SiNx | SiNx |
| | Thickness (nm) | 100 to 600 | 200 to 400 | 300 |
| | $\varepsilon r$ | 6 to 8 | 6.5 to 7.5 | 7 |
| Insulating Protection Film | Material | SiOx, SOG, SiC, SiCN | SiOx, SOG, SiC, SiCN | SiOx |
| | Thickness (nm) | 100 to 600 | 200 to 400 | 300 |
| | $\varepsilon r$ | 2 to 5 | 3 to 4 | 3.0 to 3.5 |

The radiation image detector of the examples and the embodiment is used for an X-ray image detective device for forming an image of the X-rays that has transmitted through a human body for example and is an image sensor capable of detecting an image of the X-rays and others.

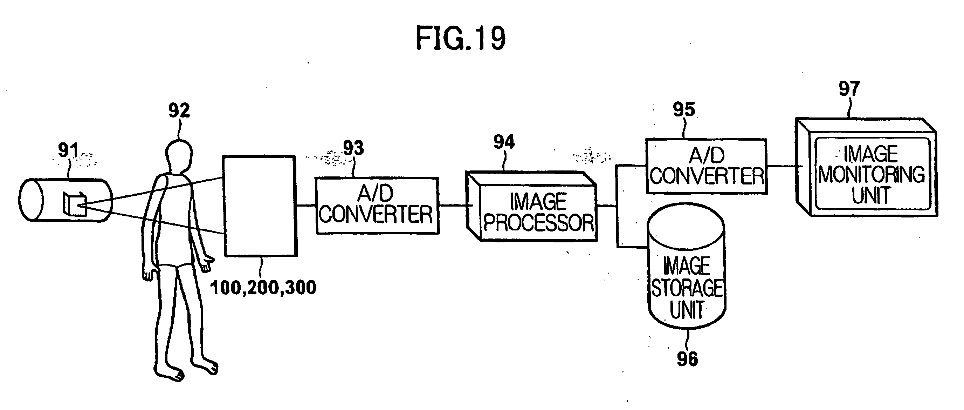

That is, a transmitted X-ray image of a specimen 92 formed by the X-rays outputted out of an X-ray tube 91 is converted into image signals by the radiation image detector 100, 200 or 300 as shown in Fig. 19 for example.

An analog signal outputted out of the radiation image detector 100, 200 or 300 is converted into a digital image signal by an A/D converter 93 and is taken into an image processor 94. The image processor 94 implements various image processing and stores images necessary to be kept in an image storage device 96. The digital image signal outputted out of the image processor 94 is converted into an analog signal by a D/A converter 95 so as to be displayed on a screen of an image monitor 97.

Furthermore, in the radiation image detector of the examples and the embodiment, the semiconductor film 6 may be made of a-Se, one in which a small amount from 0.001 ppm to 20 ppm of alkali metals such as Li, Na, K, Cs, Rb is doped to a-Se, one in which a small amount from 10 ppm to 10000 ppm of fluorides such as LiF, NaF, KF, CsF, RbF and others is doped to a-Se, one in which 50 ppm to 0.5 % of P, As, Sb or Ge is added to a-Se or one in which 50 ppm to 0.5 % of As is added and a small amount from 1 ppm to 100 ppm of Cl, Br or I is doped to a-Se. Furthermore, one in which a photo-conductive material whose main component is at least one among $Bi_{12}MO_{20}$(M: Ti, Si, Ge), $Bi_4M_3O_{12}$(M: Ti, Si, Ge), $Bi_2O_3$, $BiMO_4$(M: Nb, Ta, V), $Bi_2WO_6$, $Bi_{24}B_2O_{39}$, ZnO, ZnS, ZnTe, $MNbO_3$(M: Li, Na, K), PbO, $HgI_2$, $PbI_2$, CdS, CdSe, CdTe, $BiI_3$, GaAs and others is contained in a-Se may be utilized.

When the semiconductor film 6 generates electric charges by directly receiving the X-rays, a preferable range of its thickness is 100 $\mu$m to 2 mm.

The preferable range is 150 to 250 $\mu$m for the use of mammography and is 500 $\mu$m to 1.5 mm for the use of general radiography for medical diagnoses.

Furthermore, bismuth complex oxide may be used as the semiconductor film 6. This is described in JP 2005-274257 for example.

When an amorphous semiconductor with a-Se as a principal component thereof is used as the semiconductor film 6, in order to prevent crystallization thereof, it is also possible to provide an upper electrode interfacial layer between the semiconductor film 6 and the bias electrode 7 and a lower electrode interfacial layer between the semiconductor film 6 and the charge collecting electrode 11, to prevent such crystallization. As the electrode interfacial layers described above, one in which As is doped in a range of 1 % to 20 % to a-Se, one in which S, Te, P, Sb and Ge is doped in a range from 1 % to 10 % to a-Se, one in which a combination of the elements described above with other elements is doped to a-Se or the like may be used. Or, $As_2S_3$ and $As_2Se_3$ whose crystallization temperature is high may be used.

It is also possible to dope alkali metal such as Li, Na, K, Rb, Cs or molecules of LiF, NaF, KF, RbF, CsF, LiCl, NaCl, KCl, RbCl, CsCl, CsBr and the like in a range of 10 ppm to 5000 ppm for the purpose of preventing injection of electric charges from the bias electrode 7 or the charge collecting electrode 11 and more specifically for the purpose of preventing injection of positive holes in addition to the doped elements described above. Conversely, halogen elements such as Cl, I, Br and the like or molecules such as $In_2O_3$ may be doped in a range of 10 ppm to 5000 ppm to prevent injection of electrons. The thickness of the upper and lower electrode interfacial layers may be also set from 0.05 $\mu$m to 1 $\mu$m in order to fully achieve the aforementioned objects.

The lower electrode interfacial layer, the semiconductor film and the upper electrode interfacial layer are deposited on the substrate by keeping the substrate at temperature between normal temperature to 70°C within a vacuum chamber whose degree of vacuum is $10^{-3}$ to $10^{-7}$ Torr and by raising temperature of a boat or a pot containing each alloy described above by resistance heating or electron beams to evaporate or sublimate the alloy or compounds.

When evaporation temperature of the ingredients of the alloy largely differs from each other, it is possible to control adding and doping densities by individually controlling them by simultaneously heating plural boats corresponding to plural evaporation sources. For instance, it is possible to realize a layered structure of a-Se (As 10 %: LiF 500 ppm) / a-Se / a-Se (As 10 %) by putting As2Se3, a-Se and LiF into the boats, respectively, and by opening/closing a shutter of each boat by setting the temperature of the boat of As2Se3 at 340°C, of the boat of a-Se at 240°C and of the boat of LiF at 800°C.

The bias electrode 7 is a metal thin film and may be made of metal such as Au, Ni, Cr, Pt, Ti, Al, Cu, Pd, Ag, Mg, MgAg 3 to 20 % alloy, Mg-Ag intermetallic compound, MgCu 3 to 20 % alloy and Mg-Cu intermetallic compound. When Au is used for example, its thickness is desirable to be around 15 nm to 200 nm. When MgAg 3 to 20 % alloy is used for example, the thickness is desirable to be around 100 nm to 400 nm.

The bias electrode 7 is formed on the upper surface of the semiconductor film 6 by means of vapor deposition. The bias electrode 7 is formed by opening the shutter after melting a metal block within the boat by heating by a resistance heating method, by depositing for 15 seconds, by cooling once and by repeating this process by a plural times until when a resistance value becomes fully low.

In an indirect conversion type radiation image detector, if a layer from fluorescent bodies is formed on the semiconductor film 6, X-rays are at first absorbed in the fluorescent bodies, and charges may be generated by the semiconductor film 6 by receiving the light generated by the fluorescent bodies by the X-rays being absorbed, and the semiconductor film 6 may be made of the order of 1 $\mu$m to 20 $\mu$m thick. By so doing, since the electrostatic capacitance of the charge collecting electrode 11 becomes large, it is often unnecessary to provide a separate charge storage capacitor 5 as is done in a direct conversion type radiation image detector.

In an indirect conversion type radiation image detector the semiconductor film 6 may be formed continuously as with in a direct conversion type radiation image detector, however, a photodetection element array is often used in which the semiconductor film 6 is divided up into individual pixels. In such a case, the bias electrode 7 is connected by common lines.

In an indirect conversion type radiation image detector, since there is no need to use a material with a large X-ray absorption ability for the semiconductor film.6, amorphous silicon (a-Si) and organic compounds, which have been constructed in layers of a charge generating layer and a charge transporting layer, may be used. For example, the semiconductor film 6 may be built up on TFT switches 4 by continuously forming the semiconductor film 6 using a vapor phase epitaxy, spin coating, or dip coating method. Organic materials that may be used for the charge generating layer include materials such as benzimidazole perylene, hydroxygallium phthalocyanine, titanyl phthalocyanine, and organic materials that may be used for the charge transporting layer include materials such as tetraphenyldiamine.

Furthermore, since it is necessary in an indirect conversion type radiation image detector for the light that are generated from the fluorescent bodies that have absorbed the X-rays to pass through the bias electrode 7, electrodes that are able to transmit light, such as ITO or IZO, may be used for the bias electrode 7.

### Claims

1. An image detector (200) which is a direct conversion type image detector that directly converts irradiated radiation to electric charges in a semiconductor film (6), the image detector comprising:

a substrate (1) forming a lower part of the image detector a plurality of scan lines (101) disposed in parallel;

a plurality of data lines (3) provided as to cross with the scan lines (101),

thin film transistors (4) having source (9), drain (13) and gate electrodes (2) of which the source electrode is connected with the data lines (3), the gate electrode is connected to the scan lines (101), the transistors being arranged in a matrix; sensor sections comprising said semiconductor film (6) that generates charges when irradiated with electromagnetic radiation, each sensor section being connected to the thin film transistor (4) and provided in said matrix; and

a plurality of common lines (102) disposed so as to commonly apply bias voltage to the sensor sections provided in said matrix,

wherein each of the sensor sections further comprises a storage capacitor (5) having an upper electrode (18) and a lower electrode (14) for storing respective electric charges generated in the semiconductor film (6) when electromagnetic waves are irradiated, wherein the thin film transistors (4) are adapted to read out charges accumulated in the storage capacitor (5) to the data lines (3),

the common lines (102) are connected to the lower electrodes of the storage capacitors (5), the upper electrode thereof is connected to the drain electrode of the thin film transistor (4),

the scan lines (101) and gate electrodes (2) of the thin film transistors being formed by a first metal layer provided on the substrate (1) forming the lower part of the image detector;

the source and drain electrodes (9, 13) of the thin film transistors, the common lines (102), and the lower electrodes (14) of the storage capacitor being formed by the second metal layer, and

the data lines (3) and the upper electrodes (18) of the storage capacitors being formed by a third metal layer, wherein the image detector further comprises, disposed in this sequence:

said substrate (1);
said first metal layer;
one or more first insulating film(s) (15);
said second metal layer;
one or more second insulating film(s) (17);
said third metal layer;
one or more third insulating film(s) (12);
a fourth metal layer that forms charge collecting electrodes (11) for collecting the electric charges to the storage capacitors (5);
a semiconductor film (6) that generates the electric charges when it is irradiated by electromagnetic waves; and
a bias electrode (7) that applies bias voltage to the semiconductor film,

and wherein the charge collecting electrode (11) is connected with the upper electrode of the storage capacitor.

2. The image detector according to claim 1, wherein the common lines (102) are disposed in parallel with the data lines.

3. The image detector according to claim 1, wherein the first insulating film(s) (15) and a semiconductor layer 8 that forms the channel portion of the thin film transistor, are layered in sequence between the first metal layer and the second metal layer.

4. The image detector according to claim 1, wherein the upper electrodes (18) of the storage capacitors are disposed above the thin film transistors (4) with the second insulating film(s) (17) therebetween.

5. The image detector according to claim 1, wherein the data lines (3) extend on the second insulating films (17) above a part of the thin film transistors (4).

6. The image detector according to claim 1, wherein a thickness of the second insulating film(s) is thicker than that of the first insulating film(s).

7. The image detector according to claim 1, wherein a dielectric constant of the second insulating film(s) is lower than that of the first insulating film(s).

8. A radiation detecting system, comprising:

the image detector of claim 1;
a signal processing section for processing signals that have been outputted from the image detector;

a storage section for storing the processed signals that have been outputted from the signal processing section;

a display section for displaying images based on the processed signal that have been outputted from the signal processing section; and

a radiation source for outputting radiation toward the image detector.

**Patentansprüche**

1. Bilddetektor (200) als Direktumwandlungstyp-Bilddetektor, der aufgebrachte Strahlung direkt in elektrische Ladungen innerhalb einer Halbleiterschicht (6) umwandelt, umfassend:

ein Substrat (1) welches einen unteren Teil des Bilddetektors bildet,

mehrere Abtastleitungen (101), die parallel angeordnet sind;

mehrere Datenleitungen (3), welche derart angeordnet sind, dass sie sich mit den Abtastleitungen (101) kreuzen, Dünnschichttransistoren (4) mit Source- (9), Drain- (43) und Gate-Elektroden (2), von denen die Source-Elektrode mit den Datenleitungen (3) verbunden ist, die Gate-Elektrode mit den Abtastleitungen (101) verbunden ist, und wobei die Transistoren in einer Matrix angeordnet sind;

Sensorabschnitte, die die Halbleiterschicht (6) enthalten, welche Ladungen erzeugt, wenn sie mit elektromagnetischer Strahlung bestrahlt wird, wobei jeder Sensorabschnitt mit dem Dünnschichttransistor (4) verbunden und in der Matrix vorgesehen ist;

mehrere Gemeinschaftsleitungen (102), die derart angeordnet sind, dass sie gemeinsam eine Vorspannung an die in der Matrix befindlichen Sensorabschnitte geben,

wobei jeder der Sensorabschnitte außerdem einen Speicherkondensator (5) mit einer oberen Elektrode (18) und einer unteren Elektrode (14) zum Speichern der jeweiligen, in der Halbleiterschicht bei Bestrahlung mit elektromagnetischen Wellen erzeugten elektrischen Ladungen aufweisen, wobei die Dünnschichttransistoren (4) dazu ausgebildet sind, in dem Speicherkondensator (5) angesammelte Ladungen zu den Datenleitungen (3) hin auszulesen,

die Gemeinschaftsleitungen (102) mit den unteren Elektroden der Speicherkondensatoren (5) verbunden sind, deren obere Elektrode mit der Drain-Elektrode des Dünnschichttransistors (4) verbunden ist,

die Abtastleitungen (101) und die Gate-Elektroden (2) der Dünnschichttransistoren ausgebildet sind durch eine erste Metallschicht auf dem Substrat (1), welches den unteren Teil des Bilddetektors bildet;

die Source- und Drain-Elektroden (9, 13) der Dünnschichttransistoren, die Gemeinschaftsleitungen (102) und die unteren Elektroden (14) des Speicherkondensators durch die zweite Metallschicht gebildet sind, und

die Datenleitungen und die oberen Elektroden (18) der Speicherkondensatoren durch eine dritte Metallschicht gebildet sind,

wobei der Bilddetektor weiterhin in dieser Reihenfolge angeordnet aufweist:

das Substrat (1);

die erste Metallschicht;

einen oder mehrere Isolierschicht (15);

die zweite Metallschicht;

eine oder mehrere zweite Isolierschicht(en) (17);

die dritte Metallschicht;

eine oder mehrere dritte Isolierschicht(en) (12);

eine vierte Metallschicht, welche Ladungssammelelektroden (11) zum Sammeln der elektrischen Ladungen in den Speicherkondensatoren (5) bildet;

eine Halbleiterschicht (6) welche die elektrischen Ladungen bei Bestrahlung mit elektromagnetischen Wellen erzeugt; und

eine Vorspannelektrode (7) die eine Vorspannung an die Halbleiterschicht legt,

wobei die Ladungssammelelektrode (11) mit der oberen Elektrode des Speicherkondensators verbunden ist.

2. Bilddetektor nach Anspruch 1, bei dem die Gemeinschaftsleitungen (102) parallel zu den Datenleitungen angeordnet sind.

3. Bilddetektor nach Anspruch 1, bei dem die erste Isolierschicht bzw. die ersten Isolierschichten (15) und eine Halbleiterschicht (8), welche die Kanalzone des Dünnschichttransistors bildet, sequenziell zwischen der ersten Metallschicht und der zweiten Metallschicht gelegen sind.

**4.** Bilddetektor nach Anspruch 1, bei dem die oberen Elektroden (18) der Speicherkondensatoren oberhalb der Dünnschichttransistoren (4) mit der/den dazwischen liegenden zweiten Isolierschicht(en) (17) angeordnet sind.

**5.** Bilddetektor nach Anspruch 1, bei dem die Datenleitungen (3) sich auf den zweiten Isolierschichten (17) oberhalb eines Teils der Dünnschichttransistoren (4) erstrecken.

**6.** Bilddetektor nach Anspruch 1, bei dem eine Dicke der zweiten Isolierschicht(en) größer ist als diejenige der ersten Isolierschicht(en).

**7.** Bilddetektor nach Anspruch 1, bei dem eine die Elektrizitätskonstante der zweiten Isolierschicht(en) kleiner ist als diejenige der ersten Isolierschicht(en).

**8.** Strahlungsdetektionssystem, umfassend:

den Bilddetektor nach Anspruch 1;
einen Signalverarbeitungsabschnitt zum Verarbeiten von Signalen, die von dem Bilddetektor ausgegeben wurden;
einen Speicherabschnitt zum Speichern der verarbeiteten Signale, die von dem Signalverarbeitungsabschnitt ausgegeben wurden;
einen Anzeigeabschnitt zum Anzeigen von Bildern basierend auf dem verarbeiteten Signal, welches von dem Signalverarbeitungsabschnitt ausgegeben wurde; und
eine Strahlungsquelle zum Ausgeben von Strahlung auf den Bilddetektor.

**Revendications**

**1.** Détecteur d'images (200) qui est un détecteur d'images du type à conversion directe qui convertit directement un rayonnement irradié en charges électriques dans un film semiconducteur (6), le détecteur d'images comprenant :

un substrat (1) constituant la partie inférieure du détecteur d'images
une pluralité de lignes de balayage (101) disposées en parallèle ;
une pluralité de lignes de données (3) prévues de façon à croiser les lignes de balayage (101),
des transistors à film mince comportant des électrodes de source (9), de drain (13) et de grille (2), dont l'électrode de source est connectée aux lignes de données (3), l'électrode de grille est connectée aux lignes de balayage (101), les transistors étant agencés dans une matrice ; des sections de détecteur comprenant ledit film semiconducteur (6) qui génère des charges lorsqu'il est irradié avec un rayonnement électromagnétique, chaque section de détecteur étant connectée au transistor à film mince (4) et prévue dans ladite matrice ; et
une pluralité de lignes communes (102) disposées de façon à appliquer en commun une tension de polarisation aux sections de détecteur prévues dans ladite matrice,
dans lequel chacune des sections de détecteur comprend en outre un condensateur de stockage (5) ayant une électrode supérieure (18) et une électrode inférieure (14) pour stocker des charges électriques respectives générées dans le film semiconducteur (6) lorsque des ondes électromagnétiques sont irradiées, dans lequel les transistors à film mince (4) sont adaptés à lire les charges accumulées dans le condensateur de stockage (5) sur les lignes de données (3),
les lignes communes (102) sont connectées aux électrodes supérieures des condensateurs de stockage (5), leur électrode inférieure est connectée à l'électrode de drain du transistor à film mince (4),
les lignes de balayage (101) et les électrodes de grille (2) des transistors à film mince étant formées d'une première couche métallique prévue sur le substrat (1) constituant la partie inférieure du détecteur d'images ;
les électrodes de sources et de drain (9, 13) des transistors à film mince, les lignes communes (102) et les électrodes inférieures (14) du condensateur de stockage étant formées de la deuxième couche métallique, et
les lignes de données (3) et les électrodes supérieures (18) des condensateurs de stockage étant formées d'une troisième couche métallique,
dans lequel le détecteur d'images comprend en outre, disposés dans cet ordre :

ledit substrat (1) ;
ladite première couche métallique ;
un ou plusieurs premiers films isolants (15) ;
ladite deuxième couche métallique ;

un ou plusieurs deuxièmes films isolants (17) ;

ladite troisième couche métallique ;

un ou plusieurs troisièmes films isolants (12) ;

une quatrième couche métallique qui forme des électrodes de collecte de charges (11) pour recueillir les charges électriques dans les condensateurs de stockage (5) ;

un film semiconducteur (6) qui génère les charges électriques lorsqu'il est irradié par des ondes électromagnétiques ; et

une électrode de polarisation (7) qui applique une tension de polarisation au film semiconducteur,

et dans lequel l'électrode de collecte de charge (11) est connectée à l'électrode supérieure du condensateur de stockage.

2. Détecteur d'images selon la revendication 1, dans lequel les lignes communes (102) sont disposées en parallèle avec les lignes de données.

3. Détecteur d'images selon la revendication 1, dans lequel le ou les premiers films isolants (15) et une couche de semiconducteur (8) constituant la partie de canal du transistor à film mince sont déposés en séquence entre la première couche métallique et la deuxième couche métallique.

4. Détecteur d'images selon la revendication 1, dans lequel les électrodes supérieures (18) des condensateurs de stockage sont disposées au-dessus des transistors à film mince (4) avec le ou les deuxièmes films isolants (17) entre eux.

5. Détecteur d'images selon la revendication 1, dans lequel les lignes de données (3) s'étendent sur les deuxièmes films isolants (17) au-dessus d'une partie des transistors à film mince (4).

6. Détecteur d'images selon la revendication 1, dans lequel l'épaisseur du ou des deuxièmes films isolants est plus grande que celle du ou des premiers films isolants.

7. Détecteur d'images selon la revendication 1, dans lequel la constante diélectrique du ou des deuxièmes films isolants est inférieure à celle du ou des premiers films isolants.

8. Système de détection de rayonnement comprenant :

le détecteur d'images selon la revendication 1 ;

une section de traitement de signal pour traiter les signaux qui ont été fournis en sortie par le détecteur d'images ;

une section de mémorisation pour mémoriser les signaux traités qui ont été fournis en sortie par la section de traitement de signal ;

une section d'affichage pour afficher des images en se basant sur le signal traité qui a été fourni en sortie par la section de traitement de signal ; et

une source de rayonnement pour fournir en sortie un rayonnement vers le détecteur d'images.

# FIG.1

# FIG.2

# FIG.3

# FIG.4

# FIG.5

# FIG.6

# FIG.7

# FIG.8

FIG.9

# FIG.10

# FIG.11

# FIG.12

# FIG.13

# FIG.14

# FIG.15

# FIG.16

(1)

(2)

(3)

(4)

(5)

(6)

(7)

(8)

# FIG.17

# FIG.18

FIG.19

FIG.20

# FIG.21

# FIG.22

# FIG.23

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11190774 A
- JP 2001135809 A
- US 6323490 B1
- WO 2004073067 A1
- WO 2004077098 A
- JP 2005274257 A